(19) Europäisches Patentamt
European Patent Office
Office européen des brevets

(11) **EP 3 772 656 A1**

(12) **EUROPEAN PATENT APPLICATION**

(43) Date of publication:
**10.02.2021 Bulletin 2021/06**

(51) Int Cl.:
***G01R 15/24*** *(2006.01)*

(21) Application number: **19190756.7**

(22) Date of filing: **08.08.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ABB Schweiz AG**
**5400 Baden (CH)**

(72) Inventor: **BOHNERT, Klaus**
**5452 Oberrohrdorf (CH)**

(74) Representative: **Vossius & Partner**
**Patentanwälte Rechtsanwälte mbB**
**Siebertstrasse 3**
**81675 München (DE)**

(54) **FIBER-OPTIC SENSOR AND SYSTEM**

(57)    The disclosure relates to a fiber-optic sensor for measuring an optical phase shift between two spatial modes of an optical fiber, in particular for use in an optical voltage transformer. The present invention also relates to a system for measuring an optical phase shift comprising a fiber-optic sensor and at least one piezo-electric transducer.

Figure 1

EP 3 772 656 A1

**Description**

FIELD OF THE INVENTION

The present invention relates to a fiber-optic sensor for measuring an optical phase shift between two spatial modes of an optical fiber and a system for measuring an optical phase shift.

BACKGROUND OF THE INVENTION

Optical high voltage sensors, also referred to as optical voltage transformers, OVT, commonly make use of the linear electro-optic effect, the Pockels effect, in an electro-optic crystal such as BGO ($Bi_4Ge_3O_{12}$). Sensors are known where the full power line voltage (up to several 100 kV) is applied along the longitudinal axis of a cylinder-shaped crystal. The crystal length may be in a range between 100 and 300 mm. The high electric field strengths in the crystal's vicinity require adequate electric insulation measures to prevent dielectric breakdown. For example, the sensor may reside in a hollow-core insulator filled with pressurized $SF_6$ (Sulfur hexafluoride) gas. The sensor may also reside in a solid-state insulator comprising a body of resin-impregnated paper or resin-impregnated fiber with embedded cylinder-shaped metal foils for field steering. Another OVT known concept derives the voltage from three local electro-optic field sensors arranged along the axis of a nitrogen gas filled hollow insulator column. The insulator incorporates measures to shield the sensors from the fields of adjacent electric phases.

However, the above insulation methods have in common that they are expensive and result in a large transformer size similar to the size of conventional inductive or capacitive voltage transformers.

Further known voltage sensors measure the voltage by integrating the electric field between ground and high voltage by a series of piezo-electric quartz crystals, wherein an optical fiber senses the piezo-electric deformations of the crystals. Such sensors are applicable, e.g., for air-insulated high voltage substations and employ an interrogation technique called coherence-tuned interrogation, a technique related to white light interferometry. An alternative interrogation technique, also used in fiber-optic gyroscopes and current sensors, is based on non-reciprocal phase modulation. Furthermore, measures are known for intrinsic cancelation of mechanical perturbations of the sensor signal. These interrogation techniques require a polarization-maintaining fiber between the sensor head and the interrogator, i.e. opto-electronics module, as well as means for optical phase modulation and control.

DESCRIPTION OF THE INVENTION

The present invention relates to a fiber-optic sensor for measuring an optical phase shift between two spatial modes of an optical fiber, in particular for use in an optical voltage transformer, the fiber-optic sensor comprising: a light source configured to emit a light spectrum with a center wavelength $\lambda$; a beam splitting element configured to split light emitted by the light source; an optical fiber supporting at wavelength $\lambda$ at least a first spatial mode and a second spatial mode, wherein the beam splitting element is further configured to send two counter-propagating light signals through the optical fiber such that one pair of spatial modes is propagating from one end of the optical fiber and the other pair of spatial modes is propagating from another end of the optical fiber, wherein each pair comprises a first spatial mode and a second spatial mode; a phase-shifting element configured to enable a phase shift between the first spatial mode and the second spatial model of one of the two pairs of spatial modes, the phase-shifting element being connected to one end of the optical fiber; a first detecting element configured to detect a first interference intensity of the first and second spatial modes occurring at the one end of the optical fiber connected to the phase shifting element; a second detecting element configured to detect a second interference intensity of the first and second spatial modes occurring at the other end of said optical fiber; and a processing unit configured to calculate the optical phase shift from the detected first and second interference intensities.

Various embodiments may preferably implement the following features:
Preferably, the first interference intensity is a far field interference intensity.

Preferably, the second interference intensity is a near field interference intensity.

Preferably, the processing unit is in direct and/or wireless contact with the first and second detecting elements.

Preferably, the optical fiber is a polarization-maintaining optical fiber, in particular an elliptical core optical fiber.

Preferably, the optical fiber is birefringent.

Preferably, the optical fiber has a higher order mode cut-off wavelength above the wavelength of operation.

Preferably, the fiber is configured to support at wavelength $\lambda$ the spatial modes $LP_{01}$ and $LP_{11}$ even.

Preferably, the optical fiber comprises a first section and a second section.

Preferably, the first and second fiber sections are coupled to each other such that light propagating in the fundamental mode LP01 of the first section is coupled into the higher order mode LP11 even of the second section, light propagating in the fundamental mode LP01 of the second section is coupled into the higher order mode LP11 even of the first section, light propagating in the higher order mode LP11 even of the first section is coupled into the fundamental mode LP01 of the second section, and light propagating in the higher order mode LP11 even of the second section is coupled into the fundamental mode LP01 of the first section.

Preferably, the first and second sections are coupled such that the slow principal axis of the first section and the slow principal axis of the second section are parallel to each other and that between the core of the first section and the core of the second section is a transversal offset along the slow principal axes.

Preferably, the first and second sections are coupled by means of a single-mode polarization maintaining fiber.

Preferably, a principal axis of the single-mode polarization maintaining fiber is aligned parallel to the slow principal axes of the first section and the second section.

Preferably, the core of the single-mode polarization maintaining fiber has a transversal offset along the slow principal axis of the first section and the slow principal axis of the second section.

Preferably, the first and second fiber section provide substantially identical optical path differences for the two spatial modes.

Preferably, the fiber-optic sensor further comprises at least one polarizing element being arranged between the light source and one end of the fiber.

Preferably, the polarization direction of the at least one polarizing element is parallel to the fast or slow principal axis of the optical fiber.

Preferably, the fiber optic sensor further comprises two further beam splitting elements connected to the beam splitting element through two single-mode fibers at the side of the beam splitting element distal to the light source.

Preferably, the first detecting element is connected to one of the two further beam splitting elements and the second detecting element is connected to the other of the two beam splitting elements.

Preferably, the phase shifting element is connected to one of the two further beam splitting elements.

Preferably, the two further beam splitting elements have an asymmetric splitting ratio, preferably of 20:80.

Preferably, the phase-shifting element is configured as a gap after an end facet of the connected end of the optical fiber.

Preferably, the fiber-optic sensor further comprises a first and a second single-mode polarization-maintaining fiber lead.

Preferably, the first single-mode polarization-maintaining fiber lead is connected to an end of the optical fiber such that the gap is formed between an end facet of the optical fiber and an end facet of the first single-mode polarization-maintaining fiber lead.

Preferably, the second single-mode polarization-maintaining fiber lead is directly connected to the other end of the optical fiber.

Preferably, the end facet of the optical fiber and the end facet of the first single-mode polarization-maintaining fiber lead are cleaved at zero degree.

Preferably, the optical axis of the optical fiber and the optical axis of the first single-mode polarization-maintaining fiber lead have a transversal offset along the slow principal axis of the optical fiber.

Preferably, the end facet of the optical fiber and the end facet of the first single-mode polarization-maintaining fiber lead are cleaved at an angle $\beta$.

Preferably, the optical axis of the optical fiber and the optical axis of the first single-mode polarization-maintaining fiber lead are in line.

Preferably, the end of the optical fiber connected to the first single-mode polarization-maintaining fiber lead and the respective end of the first single-mode polarization-maintaining fiber lead are fitted in fiber connector ferrules, and wherein the fiber connectors ferrules reside in a tubular sleeve, the tubular sleeve being fitted with ferrule stops that determine the width of the gap.

Preferably, the gap is configured as a borehole in the optical fiber and/or the first single-mode polarization-maintaining fiber lead.

Preferably, the optical fiber and the first single-mode polarization-maintaining fiber lead are joint by a fusion splice.

Preferably, the phase-shifting element comprises a coreless fiber.

Preferably, the respective end of the optical fiber is connected to one end of the coreless fiber and the first single-mode polarization-maintaining fiber lead is connected to the other end of the coreless fiber.

Preferably, the second single-mode polarization-maintaining fiber lead is directly connected to the other end of the optical fiber.

Preferably, the optical phase shift is generated by fiber strain, in particular longitudinal fiber strain, exerted onto the optical fiber.

Preferably, the optical fiber is attached to at least one piezoelectric transducer element that generates the fiber strain under the influence of an electric field.

Preferably, the optical fiber is attached to the at least one piezoelectric transducer with pre-strain.

Preferably, the optical fiber has a coating being configured to fully transmit the piezo-electric deformation of the quartzes onto the optical fiber, preferably over the full temperature range of operation, preferably between -40 and 85°C.

Preferably, the at least one piezoelectric transducer element is made of or comprises crystalline quartz.

Preferably, the transducer element is of disk shape or annular shape.

Preferably, a crystallographic x-direction is aligned orthogonal to a facet of the disk shaped or annular shaped transducer element.

Preferably, the optical fiber is attached to a series of piezo-electric transducer elements configured equidistantly along a path between a high voltage electrode and a ground potential electrode and wherein a crystallographic x-direction of the piezo-electric transducer elements is aligned parallel to said path.

Preferably, the piezo-electric transducer elements are arranged as pairs of piezo-electric transducer elements along a path between a high voltage electrode and a ground potential electrode.

Preferably, a crystallographic x-direction of the first piezo-electric transducer element of a pair of piezo-electric transducer elements is anti-parallel to a crystallographic x-direction of the second piezo-electric transducer element of said pair of piezo-electric transducer elements.

Preferably, the first section of the optical fiber is attached to the first piezo-electric transducer elements of said pairs of piezo-electric transducer elements and the second section of the optical fiber is attached to the second piezo-electric transducer elements of said pairs of piezo-electric transducer elements.

Preferably, the optical phase shift represents the voltage between the high voltage electrode and ground potential electrode.

The present invention also relates to a system for measuring an optical phase shift comprising a fiber-optic sensor according to any one of the preceding preferred embodiments and at least one piezo-electric transducer element according to any one of the preceding preferred embodiments.

BRIEF DESCRIPTION OF THE DRAWINGS

The subject matter of the invention will be explained in more detail in the following text with reference to preferred exemplary embodiments which are illustrated in the attached drawings, in which:

FIG. 1 shows a schematic illustration of the configuration of a sensor head according to an embodiment of the present disclosure,
FIG. 2 shows a magnified schematic illustration of the configuration of a sensor head shown in FIG.1,
FIG. 3a, b, and c illustrate exemplary embodiments for arranging the piezoelectric elements according to an embodiment of the present disclosure,
FIG. 4a illustrates a fiber-optic sensor according to an embodiment of the present disclosure,
FIG. 4b illustrates a fiber-optic sensor according to another embodiment of the present disclosure,
FIG. 5a illustrates a cross section of an optical fiber according to an embodiment of the present disclosure,
FIG. 5b illustrates modal interference patterns according to an embodiment of the present disclosure,
FIG. 6 illustrates a graph showing interference signals of spatial modes versus differential phase of spatial modes according to an embodiment of the present disclosure,
FIG. 7 illustrates the Gouy differential phase shift between spatial modes, LP11 even and LP01, according to an embodiment of the present disclosure, and
FIG. 8 to 12 show exemplary embodiments of phase shifting elements according to an embodiment of the present disclosure.

The reference symbols used in the drawings, and their primary meanings, are listed in summary form in the list of designations. In principle, identical parts are provided with the same reference symbols in the figures.

DETAILED DESCRIPTION OF PREFERRED EMBODIMENTS

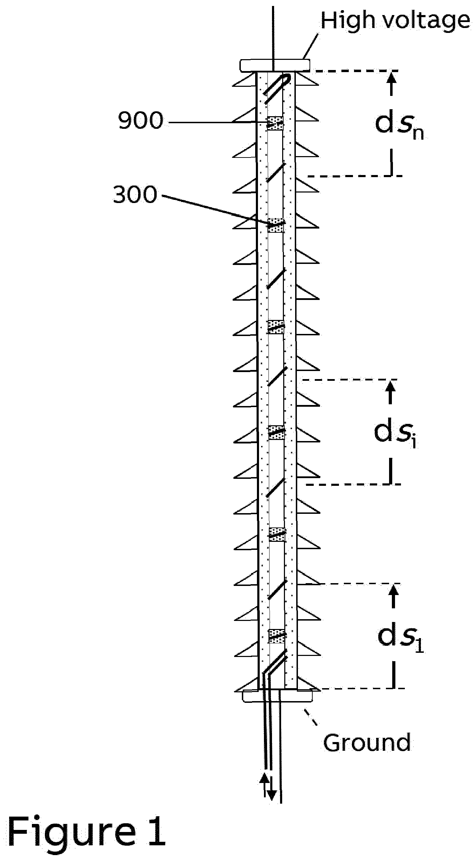

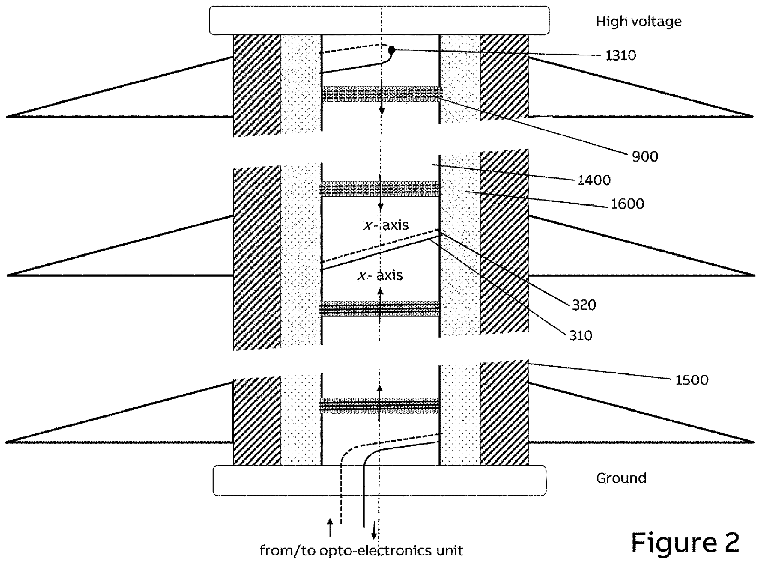

FIG. 1 relates to a schematic illustration of the configuration of a sensor head/primary converter of a voltage sensor according to an embodiment of the present disclosure. In Fig. 1, the path from the ground potential to the high voltage potential, i.e. the field integration path, comprises $n$ path segments $ds_i$. According to this embodiment, a disk-shaped quartz sensor element 900 resides in the middle of each segment with the longitudinal disk axis parallel to the integration path. That axis coincides with a 2-fold crystallographic axis ($x$-direction) as Quartz belongs to the crystal symmetry class 32 and has three 2-fold and two 3-fold axes. The alternating electric field modulates the circumferential length $L$ of the quartzes 900 due to the converse piezo-electric effect. For the given orientation, the change of the length $\Delta L$ is proportional to the field component $E_x$ parallel to the x-axis shown in FIG.2, whereas orthogonal field components (y and z directions) have no influence:

$$\Delta L = (1/2) \, d_{11} \, E_x \, L \quad \text{(a)}$$

Here, $d_{11}$ is the relevant piezo-electric coefficient ($d_{11} = 2.3 \times 10^{-12}$ m/V for Quartz). $\Delta L$ can be positive or negative, depending whether $E_x$ is parallel or anti-parallel to $x$. A number of loops of a sensing fiber 300 are wrapped with adequate pre-strain on each of the quartzes 900, for example 5-10 fiber loops per quartz element 900. Preferably, the fiber 300 is a birefringent, i.e. polarization-maintaining, fiber. The higher order mode cut-off wavelength of the fiber 300 is above the wavelength of operation, so that the fiber 300 supports two spatial modes, e.g. the $LP_{01}$ fundamental mode and $LP_{11}$ even higher order mode.

The modulation of the fiber strain by the quartzes 900 in the presence of an alternating electric field results in a corresponding modulation of the differential phase of the two fiber modes. The phase modulation $\theta$ is a measure for the voltage between the high voltage and ground potential electrodes:

$$\theta = g \, \Sigma \, \boldsymbol{E}_i \cdot \mathrm{d}\boldsymbol{s}_i \quad \text{(b)}$$

with i = 1 ... n and g being a conversion factor. Generally, the phase modulation $\theta$ is characterized by its amplitude $\theta_0$, frequency $\omega$, and phase $\varphi$: $\theta = \theta_0 \sin(\omega t + \varphi)$. For ease of simplicity, it can be assumed that $\varphi = 0$.

Hence, the sensor approximates the line integral $\int \boldsymbol{E} \cdot \mathrm{d}\boldsymbol{s}$, i.e., the voltage, by a sum $\Sigma \, \boldsymbol{E}_i \cdot \mathrm{d}\boldsymbol{s}_i$. Even though there may be a residual integration error, the sensor calibration eliminates that error for a given field distribution. Preferably, the number $n$ of path segments is chosen large enough, so that integration errors remain within specified limits, if the field distribution deviates from the situation at calibration. In practice, the civil structures of a substation for example, or influences of weather may modify the field distribution. Typical error limits are $\pm0.2\%$ and $\pm3\%$ for metering and protection applications according to International Electrotechnical Commission, IEC, accuracy classes 0.2 and 3P, respectively.

The sensitivity of the sensing fiber 300 to strain depends of the fiber parameters and the wavelength of operation. For example, a fiber elongation in the range between 0.1 and 0.5 mm may be required for a phase shift of $2\pi$ between the spatial polarization modes. In this context, it should be noted that for a given absolute fiber length change $\Delta L$ this phase shift is independent of the length $L$ of the strained fiber segment. In practice, one may preferably design the sensor such that the rated voltage produces a phase modulation with amplitude $\theta_0$ on the order of 10 mrad. This results in a signal to noise ratio of $10^5$ for a detection bandwidth of 1 Hz, if we assume a noise floor of 0.1 $\mu$rad/$\sqrt{\text{Hz}}$.

FIG. 2 shows a magnified schematic illustration of the configuration of a sensor head shown in FIG.1. In order to cancel or reduce optical phase shifts caused by mechanical perturbations of the sensor the positive x-directions according to the embodiment shown in FIG.2 alternate from quartz 900 to quartz 900, i.e., one half of the quartzes 900 have their positive x-axis pointing upward, whereas the other half have their positive x-axes pointing downward. Thus, in FIG.2, the directions alternate from quartz 900 to quartz 900 with the bottom-most quartz 900 having its positive x-direction pointing upwards. Hence, the piezo-electric deformations of the two sets of quartzes 900 are antiphase.

In the embodiment shown in FIG. 2, the sensing fiber 300 comprises two substantially identical sections 310 and 320 as illustrated with solid and dashed lines. The two substantially identical sections are joined by an offset splice 1310, i.e. with a splice having a lateral core offset as will be further described below. The offset splice 1310 swaps the two fiber modes, i.e., light that propagated in the fundamental mode in the first fiber section propagates in the higher-order mode in the second section, and light that propagated in the higher-order mode in the first fiber section propagates in the fundamental mode in the second section. Hence, at a given fiber strain the differential phase shifts of the two modes in the two sections are of opposite sign. The first section interrogates the quartzes 900 with the x-direction pointing upwards, while the second section interrogates the quartzes 900 with the x-direction pointing upwards. As a result, phase shifts produced by the electric field add up over the two sets of quartzes 900, whereas phase shifts caused by mechanical perturbation cancel out. In this context, for ease of simplicity, it is assumed that the mechanical perturbations of neighboring quartzes 900 with opposite x-directions are of the same magnitude and phase.

The fiber 300 may be wrapped onto the quartzes 900 with adequate pre-strain. Since the thermal expansion coefficient of the quartzes 900 is substantially larger than the one of the fiber 300, the pre-strain at room temperature should be sufficiently large so that a minimum strain is still maintained at the smallest operating temperature, e.g., at minus 40°C. The sensing fiber sections 310 and 320 may have a coating being configured to fully transmit the piezo-electric deformation of the quartzes 900 onto the fiber over the full temperature range of operation, particularly between -40 and 85°C. In other words, the coating may be sufficiently stiff to fully transmit the piezo-electric deformation of the quartzes 900 onto the fiber over the full temperature range of operation. Adequate coatings may include coatings from hard acrylate, polyimide, or PEEK (Polyetherether ketone). Preferably, the fiber 300 has an outer diameter of 80 $\mu$m

rather than the standard telecom fiber diameter of 125 $\mu$m for smaller bend-induced fiber stress.

The quartz end faces may have directly connected, e.g. glued-on, steel disks (not shown) which serve to connect the quartzes 900 to the dielectric spacer elements 1400 in between the quartzes 900 as steel and quartz have almost identical thermal expansion coefficients. The steel disks and spacers 1400 may be connected by springs or other flexible elements to ascertain sufficient mechanical flexibility of the structure, e.g., in case of deformation of the outer insulator tube by wind forces. Alternatively, the spacers 1400 themselves may be made from a flexible material. Instead of steel disks, disks from a dielectric material may be chosen. The fiber in between the quartzes 900 may be loosely wrapped onto the circumference of the spacers 1400 or may be guided through the interior of hollow spacers. In case of annular quartz disks, the quartzes 900 and spacers 1400 may be mounted along a flexible, central axis member.

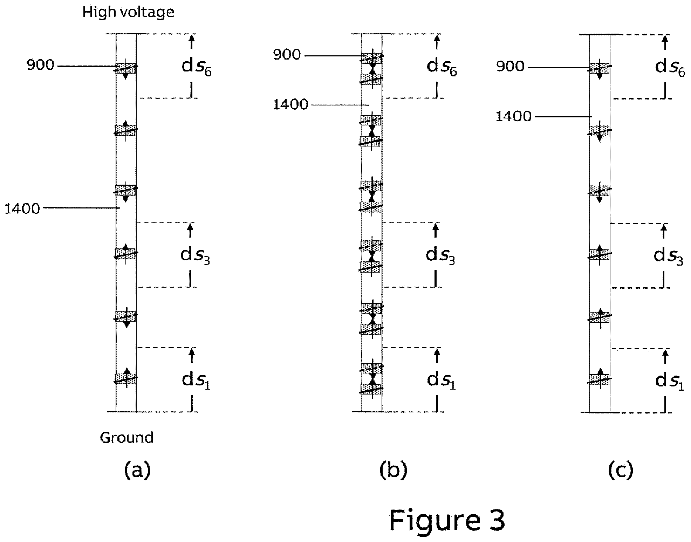

In an exemplary assembly procedure according to an embodiment, in a first step, the quartzes 900 and spacers 1400 are assembled to form a single rod-like sub-unit. Subsequently, the fiber sections 310 and 320 are attached to the structure by means of an adequate fiber winding machine. Depending on the specific quartz arrangement, as exemplarily shown for different embodiments in FIG.3 below, a parallel or serial winding scheme may be chosen for the two fiber sections 310 and 320. Finally, the fully assembled rod-like sensing body is mounted in a slender insulator column 1500, e.g., with an inner diameter of 40 mm or 50 mm as illustrated in FIG.1 and 2. Preferably, the spacers 1400 are equipped with lateral pins (not shown) that center the sensing body on the column axis. Preferably, a compressible gel or foam 1600 fills the remaining hollow volume of the column 1500. The insulator column 1500 may be equipped with corona rings (not shown) on the high voltage and/or ground potential ends for field steering.

As mentioned above, according to an exemplary embodiment, two set of quartzes 900 are used to have the piezo-electric deformations antiphase. According to various embodiments, there are several ways to arrange the two set quartzes 900. FIG. 3a and b illustrates exemplary embodiments for arranging the quartzes 900 resulting in an integration path with six segments.

In FIG. 3a, each segment ds_i comprises one quartz. The positive and negative x-directions of the quartzes 900 alternate from segment to segment.

In FIG. 3b, each path segment ds_i comprises two quartzes 900 with opposite x-directions. The distance between the two quartzes 900 of a segment may be much smaller than the length of the segment.

In FIG. 3c, the quartzes 900 are arranged with upward pointing x-directions in the bottom half of the sensor and the quartzes 900 with downward pointing x-directions in the top half of the sensor. The offset splice 1310 between the two fiber sections (not shown) is then between the two sets of quartzes 900. The quartzes 900 may have a diameter of 30 mm and a thickness of 5 mm. However, also significantly longer quartzes 900 are conceivable. According to exemplary embodiments, annular and solid quartz disk or cylinder designs are possible.

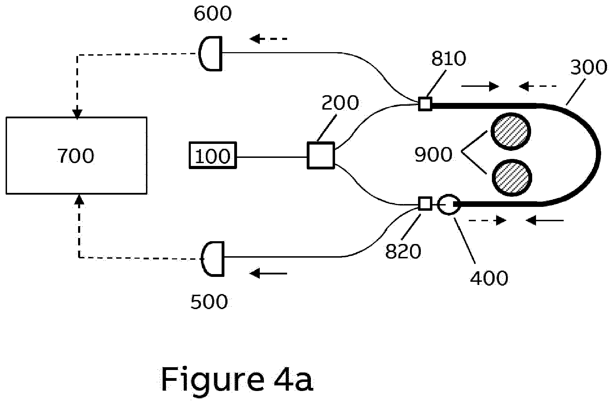

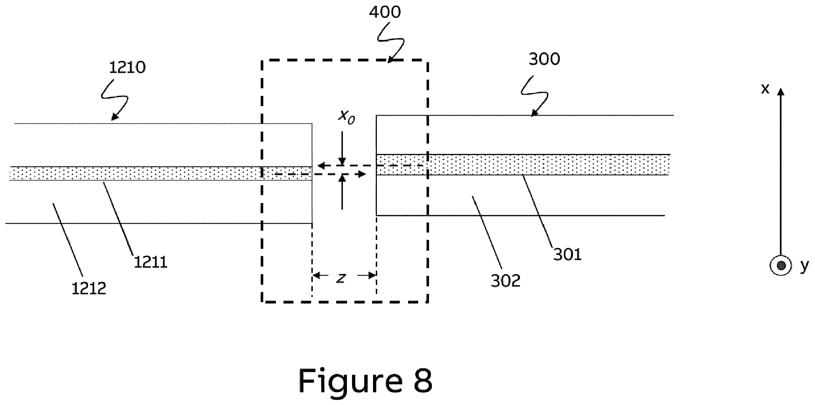

FIG. 4a illustrates a fiber-optic sensor according to an exemplary embodiment of the present disclosure. The fiber-optic sensor comprises a light source 100 which emits a light spectrum with a center wavelength $\lambda$. According to the embodiment shown in FIG. 4a, the light source 100 is preferably emitting depolarized light (depolarizer not shown). However, the skilled person understands that depending on the specific configuration of the sensor, other light source, e.g., having polarized light could be used. In this case, all fiber components are preferably polarization-maintaining fiber components. The light source 100 is connected to a beam splitting element 200, e.g. directly or e.g. via a single mode optical fiber. The light is split by the beam splitting element 200 into two single-mode fibers which are connected to beam splitting elements 810 and 820.. An optical fiber 300 supporting at wavelength $\lambda$ at least a first spatial mode and a second spatial mode is connected to the beam splitting elements 810 at one end and to a phase shifting element 400 at the other end. The phase shifting element itself is connected to the beam splitting element 820. The beam splitting element 200 is sending two counter-propagating light signals through the optical fiber 300 such that one pair of spatial modes is propagating from one end of the optical fiber 300 and the other pair of spatial modes is propagating from another end of the optical fiber 300. Each pair of spatial modes comprises a first spatial mode and a second spatial mode. The phase-shifting element 400 is enabling a static phase shift between the first spatial mode and the second spatial mode of one of the two pairs of spatial modes. Specific configurations of the phase shifting element 400 will be explained in greater detail with reference to preferred embodiments shown in FIG. 8 to 12 below. A first detecting element 500, e.g. a photodiode, is connected to the beam splitting element 820. The first detecting element 500 detects a first interference intensity of the first and second spatial modes occurring at the one end of the optical fiber 300 connected to the phase shifting element 400. In other words, the first detecting element 500 detects a first interference intensity of the first and second spatial modes occurring at the one end of the optical fiber 300 after the first spatial mode and the second spatial mode of one of the two pairs of spatial modes have passed the phase shifting element 400. A second detecting element 600, e.g. a photodiode, is connected to the beam splitting element 810. The second detecting element 600 detects a second interference intensity of the first and second spatial modes occurring at the other end of said optical fiber which is not connected to the phase shifting element 400. In other words, the second detecting element 600 detects a second interference intensity of the first and second spatial modes occurring at the other end of the optical fiber 300 after the first spatial mode and the second spatial mode of one of the two pairs of spatial modes have passed the end of the optical fiber 300.

A processing unit 700 calculates the optical phase shift $\theta$ between the two spatial modes and hence the voltage to be measured from the detected first and second interference intensities. It is clear that the processing unit 700 is thus in direct and/or wireless contact with the detecting elements 500 and 600 to receive the respective signals.

In the present embodiment, the optical phase shift $\theta$ is generated by fiber strain which is exerted onto the optical fiber 300 by attached piezo elements 900. However, it is understood by the skilled person that the current sensor is not restricted to this application. Also other sources of an optical phase shift are possible, e.g. magnetic fields, temperature, or the refractive index of a fluid surrounding the fiber. In the latter case, the fiber is modified in a way that the evanescent field of at least one of the two spatial modes reaches into the fluid.

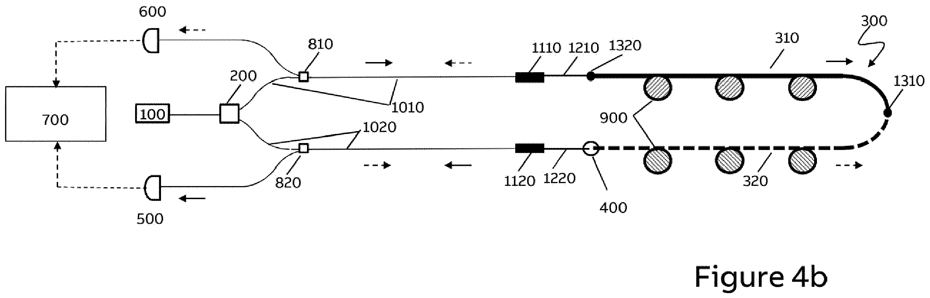

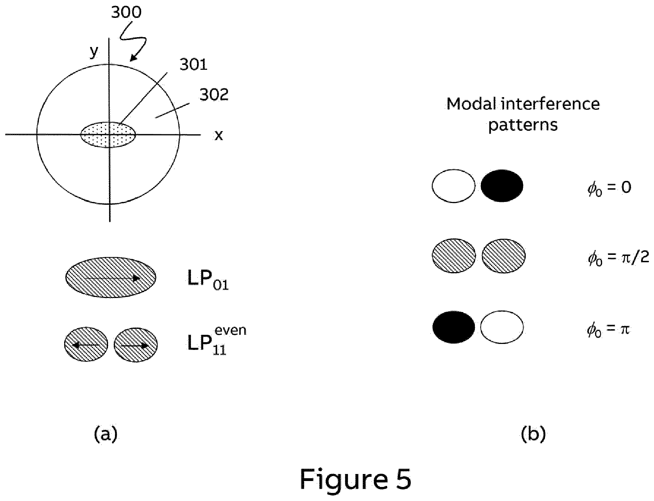

FIG. 4b illustrates a fiber-optic sensor according to another exemplary embodiment of the present disclosure. According to this embodiment, depolarized light of a broad-band light source 100, preferably a super-luminescent light emitting diode, SLED, with a center wavelength of, e.g., 1310 nm is split by a beam splitting element 200, e.g. a 1x2 fiber coupler like a 3-dB coupler, into two single-mode fibers 1010, 1020. After being polarized by two fiber polarizers 1110, 1120, the two light waves couple via polarization-maintaining fiber pigtails of the polarizers 1110, 1120 into two sections 310, 320 of the optical fiber 300, i.e. a dual-mode sensing fiber (DMF), where they excite two counter-propagating pairs of spatial fiber modes, the $LP_{01}$ and $LP_{11}$ even modes in this exemplary embodiment. This embodiment exemplarily shows two polarizers 1110, 1120. However, it is understood by the skilled person that - as a matter of principle - one of the two polarizers would be sufficient according to this embodiment. According to the embodiment shown in FIG. 4b, the optical fiber 300 comprises two fiber sections 310, 320 joined with an offset splice 1310 as also shown in the embodiment according to FIG. 2. Preferably, the sensing fiber sections 310, 320 are elliptical-core, e-core, polarization maintaining fibers, PMF. E-core PMFs support the two mentioned spatial fiber modes in a wavelength range below the so-called cut-off wavelength exclusively (see also FIG. 5 below). For example, with a cut-off wavelength between 1310 nm and 1550 nm, the optical fiber 300 supports only the fundamental mode LP01 at 1550 nm but supports both, the LP01 mode and even LP11 mode at 1310 nm. Here, it is exemplarily assumed that the cut-off wavelength of further higher order modes, in particular the $LP_{11}$ odd mode, is below 1310 nm. The polarizers 1110 and 1120 have PMF pigtails 1210, 1220, i.e. PMF leads which are oriented such that the two modes are excited with polarization along the x- or y-axis, i.e., the long or short axis of the elliptical core, that represent the slow and fast principal fiber axes (see FIG. 5 below).. According to an embodiment, the excitation along the x-axis is preferred as x-polarized modes are slightly better guided. The PMF pigtail 1210 of the upper fiber branch is spliced (offset splice 1320 in FIG. 4b) with a small lateral offset $x_0$ of its core along the x-axis with respect to the core of the subsequent DMF, such that the fundamental mode of the PMF excites the two spatial modes of the DMF with about equal amplitude in order to maximize the interference fringe contrast of the two modes. According to a preferred embodiment, an adequate offset roughly corresponds to a quarter of the mode field diameter along x-axis of the fundamental mode. As mentioned above, the two optical fiber sections are also joined with a lateral offset splice 1310 that swaps the two spatial modes of the two sections. According to this embodiment, for the PMF/DMF transition in the lower fiber branch of FIG. 4b, the so-called Gouy effect is used which is a phase anomaly reported by the French physicist Louis Georges Gouy in 1890 to introduce an extra $\pi/2$-phase differential shift for the clock-wise propagating pair of spatial modes. The two the spatial modes of a given pair interfere with each other when they again couple into the PMF pigtails 1210, 1220 on the return path. The interference signals S1, S2 of the respective spatial modes are split off from the two single-mode fiber branches upon return by beams splitting elements 810 and 820, e.g. by 1x2 fiber couplers, and then detected at detecting elements, e.g. photodiodes. Preferably, the two further beam splitting elements 810 and 820 have an asymmetric splitting ratio, e.g., of 20:80, in order to reduce the optical power that returns to the light source. As another preferred alternative, optical circulators can be used instead of beam splitting elements.

According to another preferred embodiment, instead of joining the two DMF sections by an offset splice 1310, they may be joined by a short section of an intermediate PMF (not shown) that only supports the fundamental mode LP01, wherein the LP01-mode of the PMF preferably transmits equal fractions of light from both DMF spatial modes.

An advantageous effect of using a dual-mode fiber, i.e. the optical fiber 300, is that the difference in the effective modal indices of dual mode fibers ($n_{LP01}$ - $n_{LP11}$) is up to two orders of magnitude larger than the index difference between the two orthogonal polarizations of the fundamental mode, $n_{LP01,x}$ - $n_{LP01,y}$. Hence, external disturbances such as fiber strain and bending hardly cause any cross-talk between the modes which results in a robust sensor signal.

Still another important advantage of the optical circuit and interrogation scheme according to the present disclosure is that standard single-mode fibers rather than polarization-maintaining fiber can be used before the polarizers 1110 and 1120. Also, there is no need for a modulator and corresponding control electronics. This results in substantial cost savings and simplifies the field installation of the sensor, for splicing of polarization-maintaining fiber in the field is avoided.

FIG. 5a exemplarily illustrates a cross section of the optical fiber 300, i.e. the dual mode fiber, DMF comprising the core 301 and the cladding 302. As can be seen, the core 301 is elliptical having a short axis, the y-axis in FIG.5a, and a long axis, the x-Axis in FIG.5a. The short axis is also called the fast principal axis and the long axis is also called the slow principal axis, as mentioned further above. Below the cross section of the fiber a schematic illustration of the

of $LP_{01}$ and $LP_{11}{}^{even}$ modes is shown. In this example, both modes are polarized along the x-axis, i.e. the slow principal axis as indicated by arrows in FIG. 5a.

FIG. 5b exemplarily illustrates the modal interference patterns of the $LP_{01}$ and $LP_{11}$ even modes (resulting from their spatial superposition) for three characteristic phase differences $\phi_0$ between the two modes with black areas indicating constructive interference and white areas indicating destructive interference. In this preferered embodiment, $\phi_0$ is defined as the phase difference between the modal field of the right-hand side lobe of the $LP_{11}{}^{even}$ mode and the field of the $LP_{01}$ mode. Note that the direction of the modal fields as indicate in Fig. 5a corresponds to $\phi_0 = 0$. At $\phi_0 = 0$ (modulo $2\pi$), the interference is constructive in the right-hand side lobe of the pattern and destructive in the left-hand side lobe, while at $\phi_0 = \pi$ the situation is reversed. At $\phi_0 = \pi/2$, both lobes of the pattern are balanced and have intensity corresponding to the mean of the intensities at constructive and destructive interference. Note that the interference intensities of the left and right lobes of the of the pattern are anti-phase.

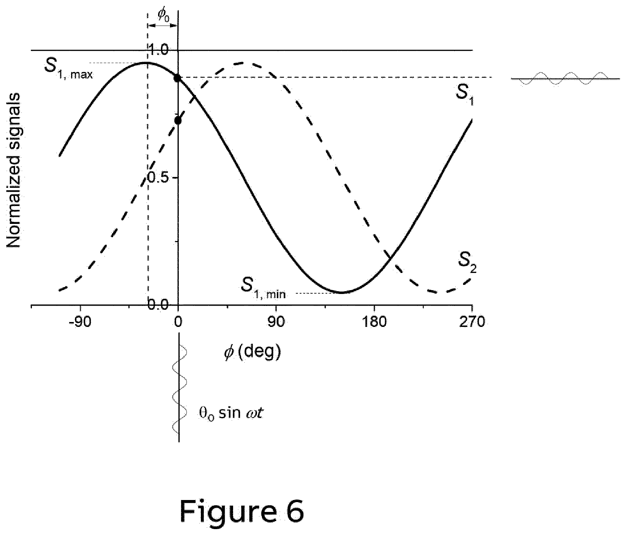

FIG. 6 illustrates an exemplary graph showing the interference signals S1, S2 of the spatial modes versus the differential phase of spatial mode $LP_{01}$, $LP_{11}$ even.

In mathematical terms, the signals S1, S2 can be written as:

$$S_1 = \tfrac{1}{2} A_1 [1 + K_1 \cos (\theta_0 \sin \omega t + \phi_0)] \qquad (1)$$

$$S_2 = \tfrac{1}{2} A_2 [1 + K_2 \sin (\theta_0 \sin \omega t + \phi_0)] \qquad (2)$$

Here, the parameters $A_i$ (i = 1, 2) are the signal amplitudes which depend on the light source power and losses in the optical circuit, e.g. the losses in the circuits of the optical sensors as shown in FIG. 4a and 4b. The term $K_i$ represents the interference fringe contrast. In equations (1), (2), we assume that the phase shift between the two spatial modes is composed of an alternating term, $\theta = \theta_0 \sin \omega t$, and a quasi-static phase difference $\phi_0$. As already mentioned above, $\theta_0$ and $\omega$ are the amplitude and frequency of the phase modulation ($\theta = \theta_0 \sin \omega t$) by the measurand, e.g., the voltage to be measured, and $\phi_0$ is a quasi-static phase difference between the spatial modes. Typically, $\phi_0$ has an arbitrary, non-zero value and may vary with temperature, since in practice the static differential modal phase shifts in the two dual-mode fiber sections are not perfectly balanced. The two signals S1, S2 vs the quasi-static phase offset $\phi0$ are out of phase by $\pi/2$ (quadrature signals) due to the above-mentioned Gouy extra differential phase shift of the clockwise propagating modes. The $\pi/2$-phase-difference makes it possible to unambiguously extract the phase modulation $\theta = \theta_0 \sin \omega t$, and hence the measurand, from S1, S2 even though the phase offset $\phi_0$ may change over time.

This will be further discussed in detail below:

For ease of simplicity it is assumed that there is a perfect $\pi/2$-phase difference between the two signals. In practice, the phase difference, i.e. the Gouy phase shift, may be somewhat less than $\pi/2$ which can be accounted for by a corresponding phase term in one of the two signals, obtained during the initial sensor calibration. However, this is understood by the skilled person in the field of technology. Thus, this term will be set to zero in the following.

Equations (1) and (2) above can be rewritten as follows:

$$S_1 = \tfrac{1}{2} A \{1 + K [\cos (\theta_0 \sin \omega t) \cos \phi_0 - \sin (\theta_0 \sin \omega t) \sin \phi_0]\} \qquad (3)$$

$$S_2 = \tfrac{1}{2} A \{1 + K [\sin (\theta_0 \sin \omega t) \cos \phi_0 + \cos (\theta_0 \sin \omega t) \sin \phi_0]\} \qquad (4)$$

Here, it is assumed that $A_1 = A_2 = A$, since the optical losses for the two light propagation directions are essentially identical. Small differences can be accounted for by calibration. For similar reasons, we assume, $K_1 = K_2 = K$. Again, K can be obtained by calibration.

Typically, the amplitude $\theta_0$ at the rated voltage is small (e.g., <0.1 rad). The signal components at frequency $\omega$ can then be approximated as:

$$S_1^{(\omega)} = -\tfrac{1}{2} A K \theta_0 \sin \phi_0 \qquad (5)$$

$$S_2^{(\omega)} = -\tfrac{1}{2} A K \theta_0 \cos \phi_0 \qquad (6)$$

Note that, more precisely, an expansion of Eq. (1, 2) by means of Bessel functions yields $2J_1(\theta_0)$ instead $\theta_0$ in Eq. (1, 2), but the difference is negligible at sufficiently small $\theta_0$.

The DC contents of the signals (1), (2) are given by:

$$S_1^{(DC)} = \tfrac{1}{2} A (1 + K \cos \phi_0) \qquad (7)$$

$$S_2^{(DC)} = \tfrac{1}{2} A (1 + K \sin \phi_0) \qquad (8)$$

The unknown quasi-static phase offset $\phi_0$ can be obtained from the ratio of (6), (7) as:

$$\phi_0 = \mathrm{atan} \, [ S_1^{(\omega)} / S_1^{(\omega)} ] \qquad (9)$$

Alternatively or in addition, $\phi_0$ can also be obtained from the ratio of the DC signal contents of (7), (8).

Since $\phi_0$ is a slowly varying parameter, the signals can be averaged, e.g. by moving average, over extended time spans such as a few seconds or longer for its computation.

With $\phi_0$ and K known, the signal amplitude A which depends on the source power is obtained from (7) and (8) according to:

$$A = 2S_1^{(DC)} / (1 + K \cos \phi_0) \qquad (10)$$

$$A = 2S_2^{(DC)} / (1 + K \sin \phi_0) \qquad (11)$$

By dividing (5) and (6) by the amplitude A from (10) and (11), the signal components at frequency $\omega$ can be normalized to:

$$S_1^{(\omega)} = -\tfrac{1}{2} K \theta_0 \sin \phi_0 \qquad (12)$$

$$S_2^{(\omega)} = -\tfrac{1}{2} K \theta_0 \cos \phi_0 \qquad (13)$$

As a result $\theta_0$ is obtained and hence the voltage to be measured, from (12) and (13) including the alternating term $\sin (\omega t + \varphi)$.

Advantageously, $\theta_0$ is determined from Eq. (12), if $\phi_0$ is in a range $(4m - 1)\, \pi/4 < \phi_0 \leq (4m+ 1)\, \pi/4$, with m being an integer, i.e., if the absolute value of the term $\cos\phi_0$ is between $1/2\sqrt{12}$ and unity and from Eq. (3) elsewhere, i.e., if the absolute value of the term $\sin\phi_0$ is between $1/2\sqrt{12}$ and unity.

In order to prevent random switching between the two regimes at times when $\phi_0$ is near a boundary, one advantageously may define appropriate "dead zones" around the boundaries, i.e., at phase offsets $\phi_0 = (4m - 1)\, \pi/4$ and $\phi_0 = (4m + 1)\, \pi/4$. This means, if $\phi_0$ enters a dead zone from one side, switching occurs only when $\phi_0$ leaves the zone at the opposite side, and no switching occurs, if $\phi_0$ leaves the zone at the side of entering. The width of the dead zones may be chosen, e.g., as 5° or 10°.

As an alternative to using the signal amplitude A from (10), (11) for normalization of the AC components (5), (6), a reference for the light source power can be measured that the signal processor uses for normalization. In that case, the amplitude A in the above equations can be set to unity.

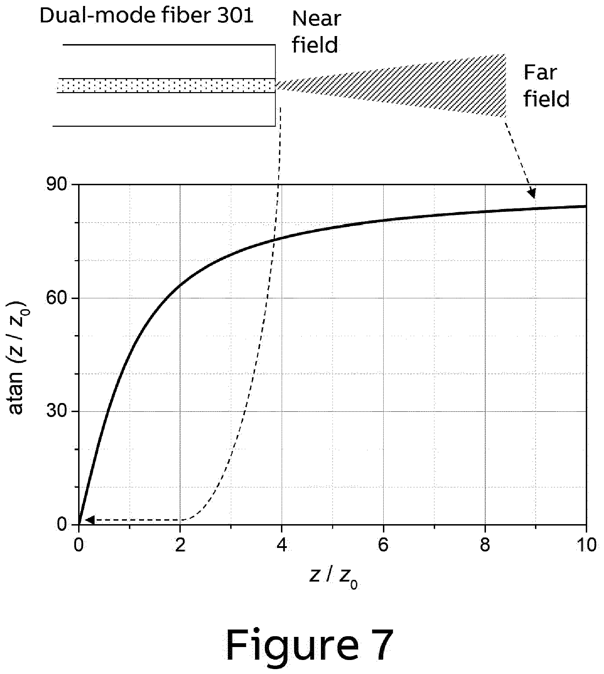

FIG. 7 illustrates the Gouy differential phase shift between the two spatial modes, LP11 even and LP01, as a function of $z/z_0$ with z being the distance from the fiber end and $z_0$ being the Rayleigh length.

When the two spatial modes, $LP_{01}$ and $LP_{11}^{even}$ of the optical fiber 300 exit the fiber and propagate in free space, or according to also preferred embodiments in a gas, a liquid or a coreless fiber, from the near field into the far field, they accumulate as a result of the Gouy effect an on-axis differential phase shift $\delta(z)$ with its absolute value given by

$$\delta = \mathrm{atan} \, (z/z_0) \qquad (14)$$

where z is the distance from the fiber end and $z_0$ is the Rayleigh length given as:

$$z_0 = \pi\, n\, r_0^2 / \lambda \qquad\qquad (15)$$

Here, $r_0$ is the radius at z = 0 at which the field of the fundamental (Gaussian) mode is reduced by a factor 1/e from its on-axis-value and n is the refractive index (n = 1 in free space). For example, a mode field diameter along the x-axis of 6 μm ($r_0$ = 3 μm) and a wavelength λ of 1300 nm results in $z_0$ = 21.7 μm. A gap between the optical fiber 300 and a PMF or - in case that the PMF is omitted - between the optical fiber and the beam splitting element 200 in the lower branch of the optical circuit of z = $5z_0$ (~110 μm) results in a differential phase shift between the two modes of about 80° which is, for the purposes of the signal processing described above, sufficiently close to the quadrature phase of 90°. The required fiber core offset $x_0$ is roughly ½ $r_0$ (1.5 μm).

As noted further above, the differential optical loss between the two beam directions and the fringe contrast terms $K_i$ can be determined during the initial sensor calibration. It is possible to also determine or verify the amplitudes $A_i$, i =1,2 and terms $K_i$ during sensor operation. To this purpose, we record during variations of the static phase offset $\phi_0$ at temperature changes the signal minima and maxima, $S_{i,min}$, $S_{i,max}$ (see Figure 6). $A_i$ and K follow then as:

$$A_i = S_{i,max} + S_{i,min} \qquad\qquad (16)$$

$$K_i = (S_{i,max} - S_{i,min})\, A_i \qquad\qquad (17)$$

The variation of $\phi_0$ with temperature can be intentionally enhanced for this purpose by wrapping a section of one of the two dual-mode fibers on a cylinder from a material with relatively high thermal expansion (e.g. from aluminum or a polymer).

FIG. 8 shows an exemplary embodiment of a phase shifting element 400. In this embodiment, the phase shifting element 400 is configured as a gap after an end facet of the connected end of the optical fiber 300. In this embodiment, the optical fiber 300 is exemplarily connected to a PMF pigtail 1210 of the polarizer 1110. The PMF pigtail 1210 comprises a core 1211 and a cladding 1212. In this embodiment, a connection between the PMF pigtail 1210 and the optical fiber 300 with a core offset $x_0$ and a gap z serves as the phase shifting element 400, which provides the desired mode mixing and coupling between the two fibers 1210 and 300 as well as an adequate Gouy phase shift, which can be achieved by appropriate mechanical fiber mounts. This solution is easily achievable but provides some asymmetry due to the core offset.

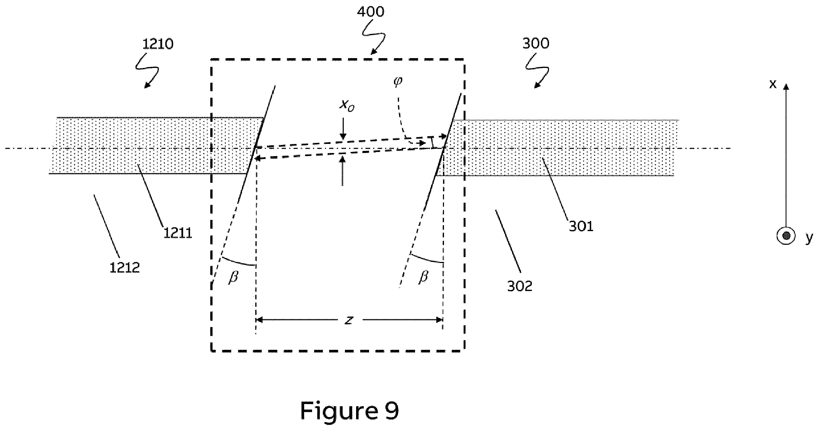

FIG. 9 shows another exemplary embodiment of a phase shifting element 400 which avoids a core-offset and asymmetry. The two fiber ends of the PMF pigtail 1210 and the optical fiber 300 are cleaved or polished at an angle β, so that the light leaves the fibers at an angle φ with respect to the optical axis. The angle β, and hence φ, is chosen such that at a given fiber gap z the beam deflection results in the desired optical offset at the respective opposite fiber end but without the need of a physical core offset. According to an example (z = 110 μm, $x_0$ = 1.5 μm), the deflection angle φ must be chosen as 0.8°. The corresponding angle β is then 1.7°. In this example, a fiber glass refractive index n of the 1.46 is chosen.

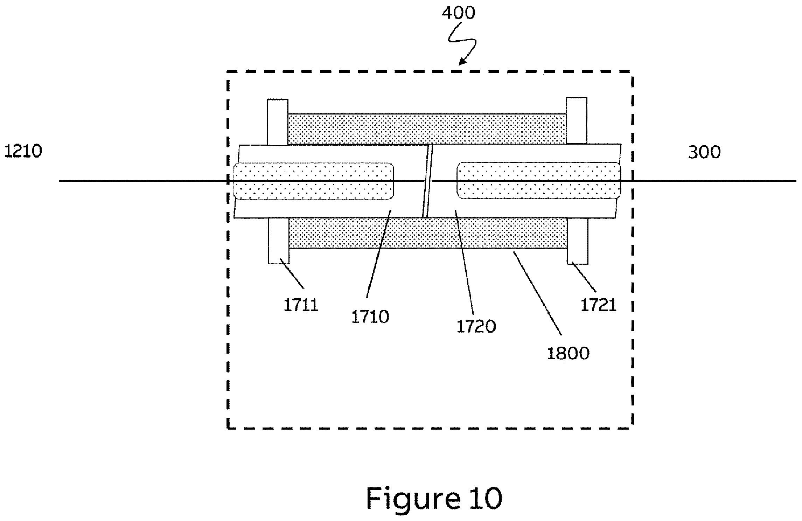

FIG. 10 shows another exemplary embodiment of a phase shifting element 400. The two fibers are inserted in connector ferrules 1710 and 1720 which are polished at angle β. The ferrules 1710 and 1720 are inserted into a ferrule sleeve 1800 as known from connector mating adapters. The ferrules 1710 and 1720 (or adequate ferrule holders which are also known from fiber connectors) are provided with ferrule stops 1711 and 1721 that ascertain the desired gap z between the fiber ends.

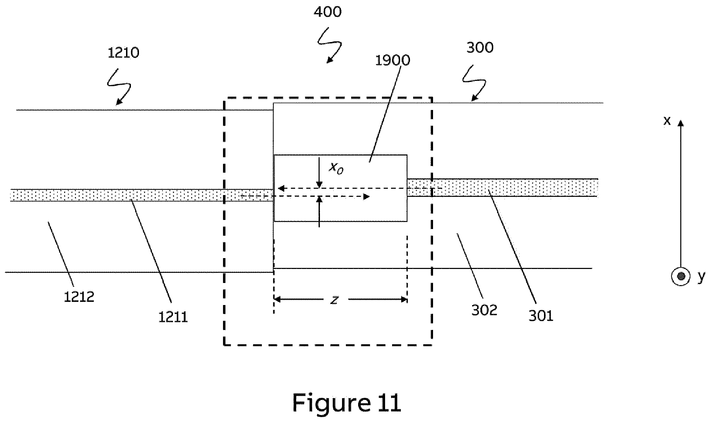

FIG. 11 shows another exemplary embodiment of a phase shifting element 400.

The optical fiber end 300 is provided with a free-space cavity 1900 of length z. The diameter, e.g., may be in the range of 2-6 fiber core diameters. The cavity 1900 enables an adequate Gouy phase shift. It is understood by the skilled person, that alternatively or in addition, the cavity may be in the PMF 1210.

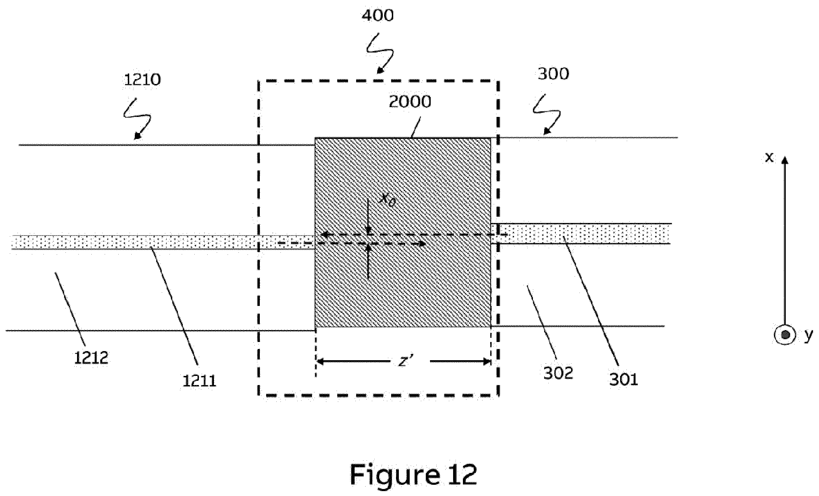

FIG. 12 shows another exemplary embodiment of a phase shifting element 400. The two fibers 1210 and 300 are fusion-spliced with a core-offset, but instead of a gap or a cavity there is an intermediate piece of coreless fiber 2000 of length z', with z' = n z with n being the refractive index of the coreless fiber. The coreless fiber 2000 enables the desired Gouy phase shift. The embodiment shown in FIG. 12 has the advantage that there are no multiple reflections between the PMF 1210 and the optical fiber 300 end faces. For assembly, a section of coreless fiber with length sufficient for splicing is spliced, e.g., to the optical fiber 300. Subsequently the coreless fiber 2000 is cleaved to the target length. Finally, the PMF 1210 is spliced to the coreless fiber 2000. Note that the exact length of the coreless fiber is not critical, since the actual phase difference between the two signals S1, S2 is determined by a calibration measurement.

REFERENCE LIST

Light source 100
Beam splitting element 200
Optical fiber 300
Fiber core 301,1211
Fiber cladding 302, 1212
1st section 310
2nd section 320
Phase shifting element 400
First detecting element 500
Second detecting element 600
Processing unit 700
Beam splitting element 810
Beam splitting element 820
Quartz transducer crystal 900
Single mode fibers 1010, 1020
Fiber Polarizer 1110, 1120
Polarizer pigtails 1210, 1220
Offset splices 1310, 1320
Dielectric spacer 1400
Insulator column 1500
Compressible gel 1600
Ferrule 1710, 1720
Ferrule stop 1711, 1721
Sleeve 1800
Cavity 1900
Coreless fiber 2000

**Claims**

1.  A fiber-optic sensor for measuring an optical phase shift between two spatial modes of an optical fiber, in particular for use in an optical voltage transformer, the fiber-optic sensor comprising:

    a light source configured to emit a light spectrum with a center wavelength $\lambda$;
    a beam splitting element configured to split light emitted by the light source;
    an optical fiber supporting at wavelength $\lambda$ at least a first spatial mode and a second spatial mode,
    wherein the beam splitting element is further configured to send two counter-propagating light signals through the optical fiber such that one pair of spatial modes is propagating from one end of the optical fiber and the other pair of spatial modes is propagating from another end of the optical fiber,
    wherein each pair comprises a first spatial mode and a second spatial mode;
    a phase-shifting element configured to enable a phase shift between the first spatial mode and the second spatial model of one of the two pairs of spatial modes, the phase-shifting element being connected to one end of the optical fiber;
    a first detecting element configured to detect a first interference intensity of the first and second spatial modes occurring at the one end of the optical fiber connected to the phase shifting element;
    a second detecting element configured to detect a second interference intensity of the first and second spatial modes occurring at the other end of said optical fiber; and
    a processing unit configured to calculate the optical phase shift from the detected first and second interference intensities.

2.  The fiber-optic sensor according to claim 1, wherein the optical fiber is a polarization-maintaining optical fiber, in particular an elliptical core optical fiber, configured to support at wavelength $\lambda$ the spatial modes LP01 and LP11 even.

3. The fiber-optic sensor according to any one of claims 1 to 2, wherein the optical fiber comprises a first section and a second section,

wherein the first and second fiber sections are coupled to each other such that
light propagating in the fundamental mode LP01 of the first section is coupled into the higher order mode LP11 even of the second section,
light propagating in the fundamental mode LP01 of the second section is coupled into the higher order mode LP11 even of the first section,
light propagating in the higher order mode LP11 even of the first section is coupled into the fundamental mode LP01 of the second section, and
light propagating in the higher order mode LP11 even of the second section is coupled into the fundamental mode LP01 of the first section and

wherein the first and second fiber section provide substantially identical optical path differences for the two spatial modes.

4. The fiber-optic sensor according to claim 3, wherein the first and second sections are coupled such that the slow principal axis of the first section and the slow principal axis of the second section are parallel to each other and that between the core of the first section and the core of the second section is a transversal offset along the slow principal axes.

5. The fiber-optic sensor according to claim 3, wherein the first and second sections are coupled by means of a single-mode polarization maintaining fiber, and
wherein a principal axis of the single-mode polarization maintaining fiber is aligned parallel to the slow principal axes of the first section and the second section and the core of the single-mode polarization maintaining fiber has a transversal offset along the slow principal axis of the first section and the slow principal axis of the second section.

6. The fiber-optic sensor according to any one of claims 2 to 5 further comprising at least one polarizing element being arranged between the light source and one end of the fiber, wherein the polarization direction of the at least one polarizing element is parallel to the fast or slow principal axis of the optical fiber.

7. The fiber-optic sensor according to any one of claims 1 to 6, wherein the phase-shifting element is configured as a gap after an end facet of the connected end of the optical fiber.

8. The fiber-optic sensor according to claim 7, further comprising a first and a second single-mode polarization-maintaining fiber lead,
wherein the first single-mode polarization-maintaining fiber lead is connected to an end of the optical fiber such that the gap is formed between an end facet of the optical fiber and an end facet of the first single-mode polarization-maintaining fiber lead,
and
the second single-mode polarization-maintaining fiber lead is directly connected to the other end of the optical fiber.

9. The fiber-optic sensor according to claim 8, wherein the end facet of the optical fiber and the end facet of the first single-mode polarization-maintaining fiber lead are cleaved at zero degree and wherein the optical axis of the optical fiber and the optical axis of the first single-mode polarization-maintaining fiber lead have a transversal offset along the slow principal axis of the optical fiber.

10. The fiber-optic sensor according to claim 8, wherein the end facet of the optical fiber and the end facet of the first single-mode polarization-maintaining fiber lead are cleaved at an angle $\beta$ and wherein the optical axis of the optical fiber and the optical axis of the first single-mode polarization-maintaining fiber lead are preferably in line.

11. The fiber-optic sensor according to any one of claims 8 to 10, wherein the end of the optical fiber connected to the first single-mode polarization-maintaining fiber lead and the respective end of the first single-mode polarization-maintaining fiber lead are fitted in fiber connector ferrules, and wherein the fiber connectors ferrules reside in a tubular sleeve, the tubular sleeve being fitted with ferrule stops that determine the width of the gap.

12. The fiber-optic sensor according to any one of claims 8 to 10, wherein the gap is configured as a borehole in the optical fiber and/or the first single-mode polarization-maintaining fiber lead, and

wherein the optical fiber and the first single-mode polarization-maintaining fiber lead are preferably joint by a fusion splice.

13. The fiber-optic sensor according to any one of claims 1 to 6, further comprising a first and a second single-mode polarization-maintaining fiber lead, wherein the phase-shifting element comprises a coreless fiber,
    wherein the respective end of the optical fiber is connected to one end of the coreless fiber and the first single-mode polarization-maintaining fiber lead is connected to the other end of the coreless fiber, and
    the second single-mode polarization-maintaining fiber lead is directly connected to the other end of the optical fiber.

14. The fiber-optic sensor according to claim 13, wherein the optical fiber is attached to at least one piezoelectric transducer element that generates the optical phase shift under the influence of an electric field, in particular wherein the at least one piezoelectric transducer element is made of or comprises crystalline quartz, the transducer element is preferably of disk shape or annular shape and a crystallographic x-direction preferably is aligned orthogonal to a facet of the disk shaped or annular shaped transducer element.

15. The fiber-optic sensor according to claim 14, wherein

    the optical fiber is attached to a series of piezo-electric transducer elements configured equidistantly along a path between a high voltage electrode and a ground potential electrode and wherein a crystallographic x-direction of the piezo-electric transducer elements is aligned parallel to said path,
    the piezo-electric transducer elements are arranged as pairs of piezo-electric transducer elements along the path between the high voltage electrode and the ground potential electrode, and wherein
    a crystallographic x-direction of the first piezo-electric transducer element of a pair of piezo-electric transducer elements is anti-parallel to a crystallographic x-direction of the second piezo-electric transducer element of said pair of piezo-electric transducer elements, and wherein
    the first section of the optical fiber is attached to the first piezo-electric transducer elements of said pairs of piezo-electric transducer elements and the second section of the optical fiber is attached to the second piezo-electric transducer elements of said pairs of piezo-electric transducer elements, and

    the optical phase shift represents the voltage between the high voltage electrode and ground potential electrode.

16. A system for measuring an optical phase shift comprising a fiber-optic sensor according to any one of claims 1 to 15 and at least one piezo-electric transducer element according to any one of claims 14 to 15.

Figure 1

Figure 2

Figure 3

(a)

High voltage

$ds_6$  $ds_3$  $ds_1$

900  1400

Ground

(b)

$ds_6$  $ds_3$  $ds_1$

900  1400

(c)

$ds_6$  $ds_3$  $ds_1$

900  1400

Figure 4a

Figure 4b

300

y

301

302

x

LP$_{01}$

LP$_{11}^{even}$

(a)

Modal interference
patterns

$\phi_0 = 0$

$\phi_0 = \pi/2$

$\phi_0 = \pi$

(b)

# Figure 5

Figure 6

Figure 7

Figure 8

Figure 9

EP 3 772 656 A1

Figure 10

EP 3 772 656 A1

Figure 11

Figure 12

Europäisches
Patentamt

European
Patent Office

Office européen
des brevets

## EUROPEAN SEARCH REPORT

Application Number

EP 19 19 0756

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2016/305984 A1 (BOHNERT KLAUS [CH] ET AL) 20 October 2016 (2016-10-20) * claim 1; figure 1 * ----- | 1-16 | INV. G01R15/24 |
| A | US 5 587 791 A (BELLEVILLE CLAUDE [CA] ET AL) 24 December 1996 (1996-12-24) * the whole document * ----- | 1-16 | |

TECHNICAL FIELDS
SEARCHED       (IPC)

G01R

The present search report has been drawn up for all claims

| Place of search | Date of completion of the search | Examiner |
|---|---|---|
| Munich | 18 November 2019 | Dogueri, Ali Kerem |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

........................................................................

& : member of the same patent family, corresponding
      document

EPO FORM 1503 03.82 (P04C01)

## ANNEX TO THE EUROPEAN SEARCH REPORT
## ON EUROPEAN PATENT APPLICATION NO.

EP 19 19 0756

This annex lists the patent family members relating to the patent documents cited in the above-mentioned European search report.
The members are as contained in the European Patent Office EDP file on
The European Patent Office is in no way liable for these particulars which are merely given for the purpose of information.

18-11-2019

| Patent document cited in search report | | | Publication date | Patent family member(s) | | | Publication date |
|---|---|---|---|---|---|---|---|
| US 2016305984 | A1 | | 20-10-2016 | AU | 2013407826 | A1 | 21-07-2016 |
| | | | | CN | 106030317 | A | 12-10-2016 |
| | | | | DK | 3084450 | T3 | 15-01-2018 |
| | | | | EP | 3084450 | A1 | 26-10-2016 |
| | | | | ES | 2654679 | T3 | 14-02-2018 |
| | | | | KR | 20160102023 | A | 26-08-2016 |
| | | | | US | 2016305984 | A1 | 20-10-2016 |
| | | | | WO | 2015090448 | A1 | 25-06-2015 |
| US 5587791 | A | | 24-12-1996 | AT | 166723 | T | 15-06-1998 |
| | | | | AU | 3467695 | A | 19-04-1996 |
| | | | | CA | 2197716 | A1 | 04-04-1996 |
| | | | | DE | 69502729 | D1 | 02-07-1998 |
| | | | | DE | 69502729 | T2 | 11-02-1999 |
| | | | | EP | 0783701 | A1 | 16-07-1997 |
| | | | | US | 5587791 | A | 24-12-1996 |
| | | | | WO | 9610187 | A1 | 04-04-1996 |

EPO FORM P0459

For more details about this annex : see Official Journal of the European Patent Office, No. 12/82